## Europäisches Patentamt
## European Patent Office
## Office européen des brevets

(11) Veröffentlichungsnummer: **0 026 331**
**A1**

# (12) EUROPÄISCHE PATENTANMELDUNG

(21) Anmeldenummer: **80105124.4**

(22) Anmeldetag: **28.08.80**

(51) Int. Cl.³: **H 05 K 5/00**
**H 02 B 1/08, H 04 Q 1/14**

(30) Priorität: **14.09.79 DE 7926187 U**

(43) Veröffentlichungstag der Anmeldung:
**08.04.81 Patentblatt 81/14**

(84) Benannte Vertragsstaaten:
**AT BE IT NL SE**

(71) Anmelder: **SIEMENS AKTIENGESELLSCHAFT Berlin und München**
**Postfach 22 02 61**
**D-8000 München 22(DE)**

(72) Erfinder: **Krautwald, Herbert, Ing. grad.**
**Klobensteinerstrasse 35**
**D-8000 München 90(DE)**

(72) Erfinder: **Klotzbach, Rudolf, Ing. grad.**
**Kameterstrasse 25**
**D-8014 Neubiberg(DE)**

(72) Erfinder: **Bettini, Dino**
**Ingeborgstrasse 34**
**D-8000 München 82(DE)**

(54) **Gehäuse für Meldezentralen.**

(57) Das Gehäuse besteht aus einer Rückwand (1), einem Deckblech (4), einem Bodenblech (3), zwei Seitenblechen (5 und 6) und einer schwenkbaren Tür (9). An den vier Ecken der Rückwand (1) ist jeweils ein sich selbst zentrierender, L-förmiger Profilträger (2a bis 2d) befestigt. Die am Rand abgewinkelten Seitenbleche (5,6) weisen an den abgewinkelten Enden Schlitze (11b), die Deckbleche (3 und 4) Durchbrüche (11a) auf, durch die sie mit den gleichen Schrauben (10a), wie die Deckbleche (3,4) am Profilträger (2a bis 2d) befestigt werden.

EP 0 026 331 A1

SIEMENS AKTIENGESELLSCHAFT       Unser Zeichen:
Berlin und München             VPA 79 P 2 3 8 7 EUR

Gehäuse für Meldezentralen.
────────────────────────────────

Die Erfindung betrifft ein Gehäuse für eine Anschluß- und Bedienungseinrichtung, vorzugsweise Meldezentrale, bestehend aus einer Rückwand, einem Deckblech, einem Bodenblech, zwei Seitenblechen und einer schwenkbaren Türe.

Anschlußeinrichtungen, insbesondere Wandschränke für Meldezentralen, fallen oft groß aus, weil eine Vielzahl externer Leitungen in der Zentrale an verschiedene Gerätebaugruppen angeschlossen werden. Deshalb fällt der konstruktiven Gestaltung des Gehäuses einer solchen Meldezentrale eine besondere Bedeutung zu.

Aufgabe der Erfindung ist es, ein stabiles Gehäuse für Meldezentralen zu schaffen, das schnell und einfach montiert werden kann und eine übersichtliche und rationelle Handhabung bei der Montage der Zentralbausteine und bei der Verdrahtung erlaubt.

En 1 Wt / 13.9.1979

Diese Aufgabe wird erfindungsgemäß dadurch gelöst, daß vier sich selbst zentrierende Profilträger an den Ecken der Rückwand befestigt sind, daß das mit entsprechenden Durchbrüchen versehene Deck- und Bodenblech und die am Rande abgewinkelten Seitenbleche mit lösbaren Arretiermitteln an den Profilträgern befestigt sind, wobei die oben und unten abgewinkelten Enden der Seitenbleche Schlitze aufweisen und die Profilträger umgreifen.

Ein Vorteil dieser Anordnung besteht darin, daß die mit Gerätebaugruppen vormontierte Rückwand, die beispielsweise über einem Kabelkanal angeordnet ist, von allen Seiten leicht zugänglich ist. Erst nach Abschluß der Montagearbeiten werden die vier Seitenbleche und die Türe angebracht.

Die an den Ecken der Rückwand befestigten Profilträger weisen je zwei Durchbrüche für die Aufnahme der Arretiermittel, z.B. Schrauben, auf. Für die lösbare Befestigung der Deck- und Seitenbleche werden nur zwei Schrauben je Profilträger benötigt. Die durch die Durchbrüche der Deckbleche führenden Schrauben gehen durch die Schlitze der abgewinkelten Enden der Seitenbleche, die den Profilträger umgreifen, und arretieren zugleich Deck- und Seitenbleche. Wenn spätere Wartungsarbeiten eine Abnahme der Seitenbleche erfordern, ist nur ein Lockern der Schrauben notwendig.

Die Profilträger besitzen einen L-förmigen Querschnitt und sind an den Ecken der Rückwand mit den Flächen nach außen angeschraubt oder angeschweißt.

Ferner sind an zwei übereinander angeordneten Profilträgern an der der Rückwand abgewandten Seite Lagerelemente, beispielsweise Scharniere, für die Aufnahme

VPA    79 P 2 3 8 7 EUR

der Türe an Zwischengliedern vorgesehen. Diese Zwischenglieder werden am Profilträger aufgesetzt und mit Arretiermitteln, z.B. zwei Schrauben je Scharnier, justierbar befestigt, um fertigungs- bzw. montagebedingte Toleranzen bezüglich der Winkeligkeit auszugleichen und somit ein exaktes Schließen der Türe zu ermöglichen.

Nach Einhängen der schwenkbaren Türe versieht man zweckmäßigerweise mindestens ein Lagerelement mit einem Sicherungsring.

In einer vorteilhaften Weiterbildung der Neuerung besitzt die Türe an der Seite, die den Scharnieren gegenüberliegt, ein winkelförmiges Führungsblech, das so angeordnet ist, daß es beim Schließen der Türe auf einem am entsprechenden Profilträger ausgeformten Stützwinkel mit einer Auflaufschräge trifft, um so der Türe ein definiertes Auflagern zu ermöglichen.

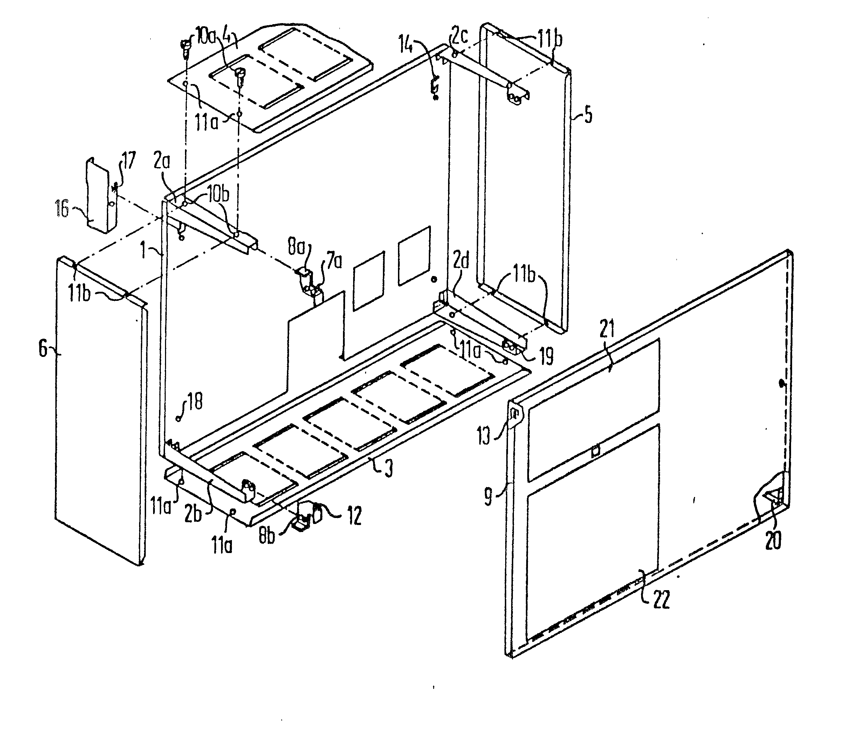

Ein Ausführungsbeispiel der Neuerung wird im folgenden anhand der Zeichnung beschrieben.

Die einzige Zeichnung zeigt ein Gehäuse für eine Meldezentrale in Exposionsdarstellung.

An der Rückwand 1 des Gehäuses sind an den vier Ecken die Profilträger 2a bis 2d befestigt. Das Bodenblech 3 und das Deckblech 4 weisen an den gegenüberliegenden Seiten je zwei Durchbrüche 11a auf. Die Seitenbleche 5 und 6 sind an den Rändern abgewinkelt. Die oberen und unteren abgewinkelten Enden der Seitenbleche 5 und 6 sind mit Schlitzen 11b versehen. Bei der Montage der Deck- und Seitenbleche 3,4,5 und 6 gehen die Schrauben 10a durch die Ausnehmungen 11a der Deckbleche 3 und 4

VPA          79 P 2 3 8 7 EUR

und durch die Schlitze 11b der Seitenbleche 5 und 6 und werden in den dafür vorgesehenen Ausnehmungen 10b der Profilträger 2a - 2d arretiert. Die Verbindungsglieder 8a und 8b, die mit den Lagerelementen 7a und 7b versehen sind, werden auf den Profilträgern 2a und 2b aufgesetzt und mit je zwei, hier nicht weiter dargestellten Schrauben an den Profilträgern 2a und 2b arretiert. Die Türe 9 weist entsprechende Gegenlagerelemente 13 auf und kann nach dem Einhängen mit einem Sicherungsring 12 am Lagerelement 7b gesichert werden. Der Profilträger 2d ist an der der Rückwand abgewandten Seite so ausgeformt, daß er einen Stützwinkel 19 mit einer Auflaufschräge aufweist zur definierten Auflage der Türe 9. Dementsprechend ist an der Türe 9 ein winkelförmiges Führungsblech 20 angebracht. An der Türe 9 sind Ausnehmungen vorgesehen für ein Bedienungsfeld 21 und ein Tableau 22. Ferner sind an der Rückwand 1 Haken 14 angebracht, um das Gehäuse an entsprechenden Befestigungswinkeln 16, die an der Wand befestigt sind, einzuhängen. Hierfür sind an diesen Befestigungswinkeln 16 Aussparungen 17 vorgesehen. Mit Schrauben läßt sich die Rückwand 1 durch die Ausnehmungen 18 an den Befestigungswinkeln befestigen.

5 Patentansprüche
1 Figur

VPA 79 P 2 3 8 7 EUR

## Patentansprüche

1. Gehäuse für eine Anschluß- und Bedienungseinrichtung, vorzugsweise Meldezentrale, bestehend aus einer Rückwand, einem Deckblech, einem Bodenblech, zwei Seitenblechen und einer schwenkbaren Türe,
d a d u r c h g e k e n n z e i c h n e t, daß vier sich selbst zentrierende Profilträger (2a bis 2d) an den Ecken der Rückwand (1) befestigt sind, daß das mit entsprechenden Durchbrüchen (11a) versehene Deck- und Bodenblech (3,4) und die am Rande abgewinkelten Seitenbleche (5,6) mit lösbaren Arretiermitteln (10) an den Profilträgern (2a bis 2d) befestigt sind, wobei die oben und unten abgewinkelten Enden der Seitenbleche (5,6) Schlitze (11b) aufweisen und die Profilträger (2a bis 2d) umgreifen.

2. Gehäuse nach Anspruch 1,
dadurch gekennzeichnet, daß die Profilträger (2a bis 2d) L-förmigen Querschnitt besitzen und an der Rückwand (1) angeschraubt oder angeschweißt sind.

3. Gehäuse nach Anspruch 1 oder 2,
dadurch gekennzeichnet, daß an zwei übereinander angeordneten Profilträgern (2a,2b) Lagerelemente (7a,7b) mit justierbaren Zwischengliedern (8a,8b) mit Arretiermitteln befestigt sind.

4. Gehäuse nach einem der Ansprüche 1 bis 3,
dadurch gekennzeichnet, daß ein Lagerelement (7b) einen Sicherungsring (12) aufweist.

VPA 79 P 2 3 8 7 EUR

5. Gehäuse nach einem der Ansprüche 1 bis 4, dadurch gekennzeichnet, daß ein nicht mit einem Lagerelement (7a,7b) versehener Profilträger (2d) einen Stützwinkel (19) mit einer Auflaufschräge als definiertes Auflager für die mit einem Führungsblech (20) versehene Türe (9) aufweist.

1/1

Europäisches
Patentamt

EUROPÄISCHER RECHERCHENBERICHT

0026331

Nummer der Anmeldung

EP 80 10 5124.4

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| | DE - U1 - 7 828 474 (SIEMENS) <br><br> * Ansprüche 1, 4, 5; Fig. 1 bis 3 * <br><br> -- <br><br> DE - A - 2 043 699 (SIEMENS) <br><br> * Seite 4, Zeile 11 bis Seite 5, Zeile 17; Fig. 1 und 2 * <br><br> -- | 1,2 <br><br><br><br><br> 1,2 |
| A | DE - A - 2 131 772 (KNÜRR KG) <br><br> * Seite 6, Zeilen 1 bis 31; Fig. 2 * <br><br> ---- | |

**KLASSIFIKATION DER ANMELDUNG (Int.Cl.3)**

H 05 K 5/00

H 02 B 1/08

H 04 Q 1/14

**RECHERCHIERTE SACHGEBIETE (Int. Cl.3)**

H 02 B 1/02

H 02 B 1/08

H 02 B 15/04

H 02 G 3/08

H 04 Q 1/04

H 04 Q 1/14

H 05 K 5/00

H 05 K 7/18

**KATEGORIE DER GENANNTEN DOKUMENTE**

X: von besonderer Bedeutung

A: technologischer Hintergrund

O: nichtschriftliche Offenbarung

P: Zwischenliteratur

T: der Erfindung zugrunde liegende Theorien oder Grundsätze

E: kollidierende Anmeldung

D: in der Anmeldung angeführtes Dokument

L: aus andern Gründen angeführtes Dokument

&: Mitglied der gleichen Patentfamilie, übereinstimmendes Dokument

| | | | |
|---|---|---|---|
| X | Der vorliegende Recherchenbericht wurde für alle Patentansprüche erstellt. | | |
| Recherchenort <br> Berlin | Abschlußdatum der Recherche <br> 23-12-1980 | Prüfer <br> HAHN | |

EPA form 1503.1 06.78